# EUROPÄISCHE PATENTSCHRIFT

(11) **EP 2 521 850 B1**
(45) Veröffentlichungstag und Bekanntmachung des Hinweises auf die Patenterteilung: **12.03.2014**
(21) Anmeldenummer: 10798545.9
(22) Anmeldetag: 20.12.2010
(51) Int. Cl.: F02D 41/14, F02M 25/07, G05B 13/02

(54) **VERFAHREN ZUM REGELN DER DURCH EINE REIBUNG GEHEMMTEN BEWEGUNG EINES BAUTEILS ODER MASCHINENELEMENTS**
METHOD FOR CONTROLLING THE MOTION OF A COMPONENT OR MACHINE ELEMENT INHIBITED BY FRICTION
PROCÉDÉ DE RÉGULATION DU MOUVEMENT D'UNE PIÈCE OU D'UN ÉLÉMENT DE MACHINE GÊNÉ PAR UN FROTTEMENT

(30) Priorität: 08.01.2010 DE 102010000744
(43) Veröffentlichungstag der Anmeldung: 14.11.2012
(73) Patentinhaber: Robert Bosch GmbH, 70442 Stuttgart (DE)
(72) Erfinder: SILBERBAUER, Martin, A-1050 Wien (AT); NEUBURGER, Robert, A-1120 Wien (AT); ZIMMERMANN, Gerald, A-1100 Wien (AT); ZIMMERMANN, Klaus, Bangalore 560095 (IN)
(86) Internationale Anmeldenummer: PCT/EP2010/070186
(87) Internationale Veröffentlichungsnummer: WO 2011/083034

(56) Entgegenhaltungen:
- DE-A1- 3 731 983
- DE-A1- 19 647 219
- US-A1- 2004 231 641

## Beschreibung

Die vorliegende Erfindung betrifft Verfahren zum Regeln der durch eine Reibung gehemmten Bewegung eines Bauteils oder Maschinenelements.

Obwohl nachfolgend hauptsächlich auf Abgasrückführventile in Kraftfahrzeugen Bezug genommen wird, ist die Erfindung nicht darauf beschränkt, sondern vielmehr auf alle Arten von reibungsgehemmten Bewegungsregelungen gerichtet. Rein beispielhaft sei hier die Bewegung von Roboterarmen, Ventilklappen im allgemeinen, Motoren im allgemeinen (z.B. elektrisch, hydraulisch, pneumatisch) usw. genannt.

### Stand der Technik

Die Abgasrückführregelung vermindert in Teillast die NOx-Emmission. Für diese Abgasrückführung vom Abgasrohr zum Saugrohr wird ein kontinuierlich verstellbares AGR-Ventil eingesetzt und dessen Öffnungsstellung geregelt. Ein AGR-Ventil wird üblicherweise von einem Gleichstrommotor angetrieben, der von einem Steuergerät (z.B. ECU oder EDC) über eine sog. H-Brücke kontinuierlich angesteuert wird. Ein Positionsrückmelder am AGR-Ventil gibt einen Positions-Istwert an das Steuergerät. Es wird üblicherweise eine PID-Lageregelung eingesetzt.

Ein PID-Lageregler kann jedoch nur mit dem I-Anteil die Reibung (Haftreibung und/oder Gleitreibung) überwinden. Die Verstärkung des I-Anteils muss aber klein gehalten werden, um ein Schwingen des Regelkreises bei niedrigen Frequenzen zu vermeiden. Es dauert daher entsprechend lange, bis z.B. die Haftreibung überwunden wird. Es ergibt sich ein langsames, dreieckförmiges Pumpen des I-Anteils mit einer Amplitude, die der Haftreibung entspricht.

Die US 2004/0231641 A1 beschreibt ein Verfahren zum Regeln einer durch Reibung gehemmten Bewegung eines Maschinenbauteils mit einer selbstlernenden Vorsteuerung, wobei die Bestimmung eines Vorsteuerwerts in Abhängigkeit von einem Istwert erfolgt. Die DE 196 47 219 A1 beschreibt ein Verfahren, bei dem ein Vorsteuerwert verändert wird, wenn ein einerseits ein Haften oder andererseits ein Schwingen des Maschinenbauteils erkannt wird. In der DE 37 31 983 A1 wird ein Vorsteuerkennfeld in Abhängigkeit von der Regelabweichung adaptiert wird.

Es ist wünschenswert, eine verbesserte Regelung für reibungsgehemmte Bewegungen vorzuschlagen.

### Offenbarung der Erfindung

Erfindungsgemäß wird ein Verfahren zum Regeln der durch eine Reibung gehemmten Bewegung eines Bauteils oder Maschinenelements mit den Merkmalen des Patentanspruchs 1 vorgeschlagen. Vorteilhafte Ausgestaltungen sind Gegenstand der Unteransprüche sowie der nachfolgenden Beschreibung.

### Vorteile der Erfindung

Die Erfindung basiert auf dem Ansatz, die Reibung, insbesondere Haftreibung, am Stellglied zu kompensieren, so dass der Regler eine Regelstrecke ohne Reibung sieht. In der Folge kann der Regler insbesondere mit mit einfachen Einstellregeln, z.B. gemäß dem Ziegler-Nichols-Verfahren o.ä., appliziert werden. Dazu wird eine adaptive Vorsteuerung eingesetzt, die den Betrag der Reibung in jedem Arbeitspunkt während des normalen Betriebes lernt. Es wird ein Vorsteuerwert variabel bestimmt, der eine momentan vorhandene Reibung kompensieren soll. Das Lernen während des normalen Betriebes ist besonders vorteilhaft, da sich die die Bewegung des Stellgliedes hemmende Reibung ständig ändern kann. Beispielsweise bei einem AGR-Ventil ist die Reibung im Wesentlichen abhängig von Verrußung und Arbeitspunkt. Auch eine rasche Änderung der Reibung durch plötzlichen Abfall von Rußbelag am Stellglied ist möglich. Auch kann sich bei Bewegungen im Allgemeinen die Reibung bspw. durch Verschmutzung, Verdickung oder Schwund von Schmiermitteln usw. ändern, so dass die Erfindung hier besondere Vorteile entfaltet. Das Lernen erfolgt zweckmäßigerweise auf Grundlage eines Istwerts, wobei damit auch von einem Istwert abgeleitete Größen wie z.B. eine Regelabweichung, Differentiale usw. umfasst sind. Im Unterschied zu üblichen Vorsteuerungen wird ein veränderlicher Vorsteuerwert verwendet, wobei die Veränderung des Vorsteuerwerts in Abhängigkeit von dem Istwert bestimmt wird.

Es sind AGR-Ventile bekannt, welche direkt von einem Torquemotor betätigt werden. Ein Torquemotor hat ein hohes Drehmoment, so dass kein Getriebe zwischen Motor und AGR-Ventil notwendig ist. Die Lebensdauer eines Getriebes könnte sich durch die Reibungskompensation verringern. Ein derartiges getriebelos betätigtes AGR-Ventil erscheint daher für die Anwendung dieser Erfindung besonders geeignet.

In Ausgestaltung wird der Vorsteuerwert auf Grundlage der Betrachtung des zeitlichen Verlaufs einer Differenz zwischen einem Vergleichssignal und einem Vorgabewert bestimmt. Das Vergleichssignal kann z.B. als Differenz zwischen dem Istwert und einem gefilterten, bspw. PT1-gefilterten, Istwert gewonnen werden oder durch die Regelabweichung definiert sein. Zweckmäßigerweise ist der Vorgabewert Null, so dass der zeitliche Verlauf des Vergleichssignals alleine betrachtet werden kann.

Erfindungsgemäß wird der Vorsteuerwert auf Grundlage der Betrachtung des zeitlichen Verlaufs einer Differenz zwischen der Regelabweichung und dem Vorgabewert bestimmt.

Erfindungsgemäß wird der Vorsteuerwert auf Grundlage der Betrachtung des zeitlichen Verlaufs der Differenz zwischen der Regelabweichung und dem Vorgabewert in Hinblick auf einen Vorzeichenwechsel bestimmt. Mit anderen Worten kann die Adaption basierend auf dem Vorzeichenwechselverhalten der Differenz zwischen Regelabweichung und Vorgabewert betrachtet werden. Vorzeichenwechsel sind besonders einfach festzustellen.

Erfindungsgemäß wird bei einem Vorzeichenwechsel der Vorsteuerwert verringert. Die Adaption kann in bevorzugter Ausgestaltung dergestalt ausgeführt werden, dass der Vorsteuerwert vergrößert wird, wenn innerhalb eines vorgegebenen ersten Zeitraums kein Vorzeichenwechsel auftritt. Die Veränderung des Vorsteuerwerts kann schrittweise oder kontinuierlich, insbesondere unter Verwendung eines Integrierglieds, erfolgen.

Zweckmäßigerweise wird ein Vorzeichenwechsel nur berücksichtigt, wenn der Betrag der Differenz zwischen der Regelabweichung und dem Vorgabewert nach dem Vorzeichenwechsel einen vorgebbaren Band-Schwellwert überschreitet. Mit anderen Worten werden Vorzeichenwechsel innerhalb eines vorgegebenen Bandes um den Vorgabewert nicht berücksichtigt. Ein Rauschen am Istwert würde bspw. zu zusätzlichen Vorzeichenwechseln an der Regelabweichung und damit zu einer fehlerhaften Verringerung des Vorsteuerwerts führen. Daher wird ein erkannter Vorzeichenwechsel nicht berücksichtigt, wenn der Absolutwert der Differenz zwischen Regelabweichung und Vorgabewert kleiner ist als der Band-Schwellwert.

Es ist zweckmäßig, den in die Regelabweichung eingehenden Sollwert zu filtern, um ein Rauschen zu verringern. Da bspw. der Sollwert des AGR-Lagereglers aus Sensorsignalen, wie z.B. Fahrpedalstellung, Drehzahl usw., berechnet wird, kann das Sollwertsignal mit Rauschen behaftet sein. Ein Rauschen würde zu zusätzlichen Vorzeichenwechseln an der Regelabweichung und damit zu einem zu geringen Vorsteuerwert führen. Als Filter kann bspw. ein PT1-Filter eingesetzt werden.

Es ist von Vorteil, wenn der Vorsteuerwert nicht verändert wird, wenn sich das Bauteil oder Maschinenelement an einem Anschlag befindet, da ein Anschlag als Reibung erkannt werden würde, was zu einer Verfälschung des Vorsteuerwerts führt.

In Ausgestaltung wird der Vorsteuerwert verringert wird, wenn eine Schwingung der Bewegung erkannt wird. Dies ist vorteilhaft, um die Schwingneigung zu reduzieren.

Die Erfindung eignet sich gut zur Regelung der Bewegung einer Klappe eines Abgasrückführventils, wobei der Vorsteuerwert zusätzlich in Abhängigkeit von der Istposition der Klappe und einem Abgasgegendruck verändert werden kann. Es ist vorteilhaft, beispielsweise mit Kennfeldern abhängig von Istposition und Abgasgegendruck die gelernte Reibung additiv oder multiplikativ zu korrigieren, um davon hervorgerufene scheinbare Reibungseffekte von der Adaption auszuschließen. Bspw. steigt die zur Verstellung des AGR-Ventils aufzuwendende Kraft mit dem Abgasgegendruck an. Ebenso kann eine Abhängigkeit der Kraft von der Istposition existieren.

Es ist zweckmäßig, den Vorsteuerwert in Abhängigkeit von der Geschwindigkeit der Bewegung des Bauteils oder Maschinenelements zu korrigieren, um Haftreibung und Gleitreibung zu trennen. Wenn sich das Stellglied bewegt, hat es die Haftreibung überwunden. Beispielsweise mit einer Kennlinie kann der gelernte Reibungswert multiplikativ korrigiert werden. Bei höheren Bewegungsgeschwindigkeiten wird durch Faktoren kleiner 1 ein der Gleitreibung entsprechender Wert kompensiert.

Vorteilhafterweise wird die Art der Bestimmung des Vorsteuerwerts in Abhängigkeit von der Geschwindigkeit der Bewegung des Bauteils oder Maschinenelements verändert. Beispielsweise mit einer Kennlinie kann das Lernen der Reibung verlangsamt oder abgeschaltet werden, wenn sich das Stellglied bewegt, da im Wesentlichen nur die Haftreibung adaptiert werden soll. Bei höheren Bewegungsgeschwindigkeiten wird durch Faktoren kleiner 1 das Lernen verlangsamt.

Eine erfindungsgemäße Recheneinheit, z.B. ein Steuergerät eines Kraftfahrzeugs, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

### Kurze Beschreibung der Zeichnungen

Figur 1 zeigt einen Ausschnitt eines Regelkreises gemäß einer bevorzugten Ausführungsform der Erfindung.
Figur 2 zeigt einen Ausschnitt des Regelkreises gemäß Figur 1 in detaillierterer Darstellung.
Figur 3 zeigt einen Verlauf einer Regelabweichung sowie des sich daraus ergebenden Vorsteuerwerts bei einem Regelkreis gemäß den Figuren 1 und 2.
Figur 4 zeigt einen Verlauf von Sollwert und Istwert sowie den zugehörigen Verlauf der Stellgröße.
Figur 5 zeigt einen Regelkreis gemäß einer weiteren bevorzugten Ausführungsform der Erfindung.
Figur 6 zeigt einen Verlauf einer Regelabweichung sowie des sich daraus ergebenden Vorsteuerwerts bei einem Regelkreis gemäß Figur 5.

### Ausführungsform(en) der Erfindung

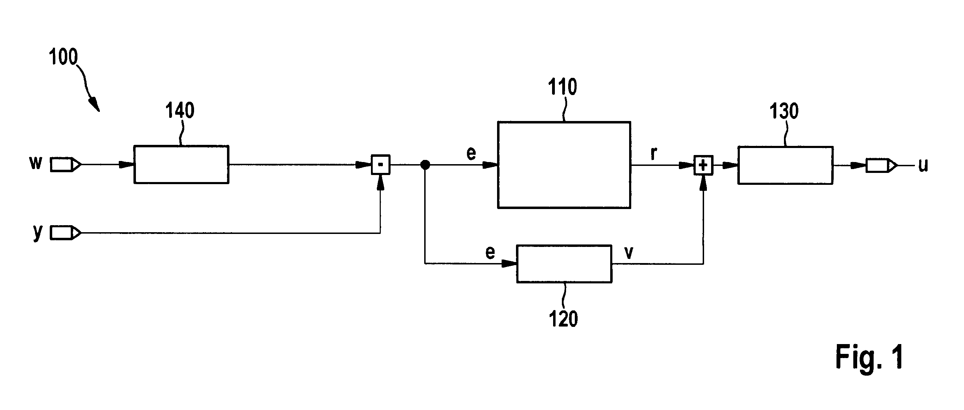

In Figur 1 ist ein Ausschnitt 100 eines Regelkreises dargestellt, der gemäß einer besonders bevorzugten Ausführungsform der Erfindung zur Bewegungsregelung, beispielsweise einer Ventilklappe eines AGR-Ventils, dient. In dem Regelkreis ist ein Regelglied 110 enthalten, welches vorliegend als PID-Regelglied ausgebildet ist. Das Regelglied 110 stellt in Reaktion auf eine Regelabweichung e eine Reglerausgangsgröße r bereit. Die Regelabweichung wird als Differenz einer Führungsgröße (Sollwert) w und eines Istwerts y bestimmt. Die Führungsgröße w kann über ein optionales Slew-Rate-Glied 140 geführt werden.

Die Regelabweichung e wird weiterhin einem Vorsteuerglied 120 zugeführt, welches adaptiv einen Vorsteuerwert v bestimmt, welcher zur Reglerausgangsgröße r addiert wird. Die Summe aus Reglerausgangsgröße r und Vorsteuerwert v wird einem optionalen Glied 130 zur Stellgrößenbeschränkung zugeführt, welches eine Stellgröße u ausgibt.

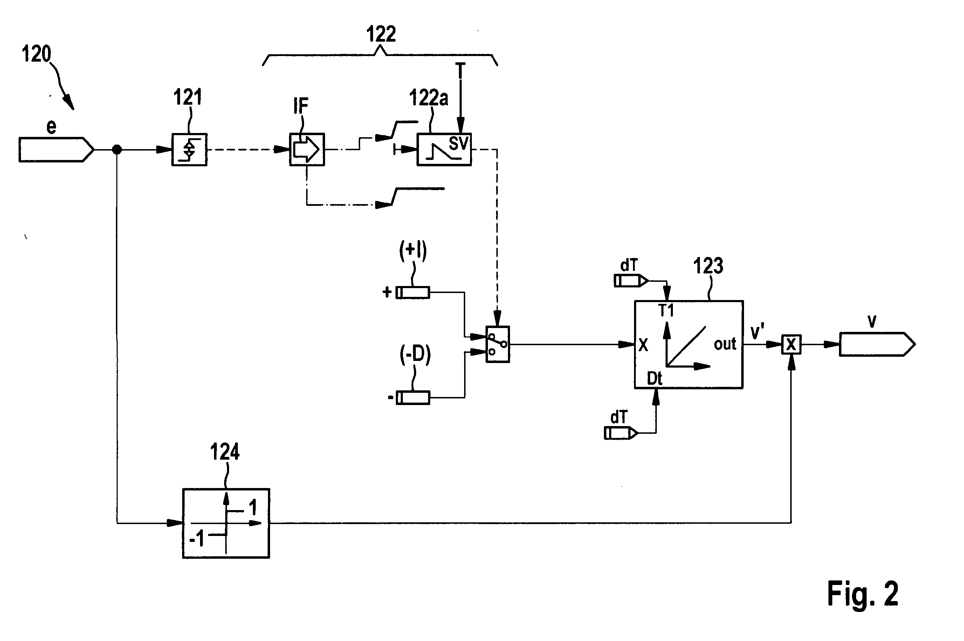

In Figur 2 ist eine erste bevorzugte Ausführungsform des Vorsteuerglieds 120 detaillierter dargestellt. Wie erläutert, wird dem Vorsteuerglied 120 die Regelabweichung e zugeführt, aus der der Vorsteuerwert v bestimmt wird.

Innerhalb des Vorsteuerglieds 120 wird die Regelabweichung e einem Glied 121 zur Bestimmung eines Vorzeichenwechsels zugeführt. An das Glied 121 schließt sich ein Glied 122 an, welches eine Integrationskonstante zur Vorgabe der Integrationsgeschwindigkeit und -richtung für einen Integrator 123 vorgibt. Wird ein Vorzeichenwechsel erkannt, wird dem Integrator 123 eine negative Integrationskonstante -D vorgegeben. Gleichzeitig wird ein Zeitglied 122a gestartet, welches in einem vorgebbaren Zeitraum T abläuft. Tritt innerhalb des Zeitraums T kein erneuter Vorzeichenwechsel auf, d.h. wird das Zeitglied 122a nicht erneut gestartet, läuft es ab und schaltet dem Integrator 123 eine positive Integrationskonstante +I zu.

Der Integrator 123 bestimmt in Abhängigkeit von der Integrationskonstante einen Lernwert v'. Der Lernwert v' wird mit dem über ein Vorzeichenglied 124 bestimmten Vorzeichen der Regelabweichung e multipliziert, um den Vorsteuerwert v zu bilden.

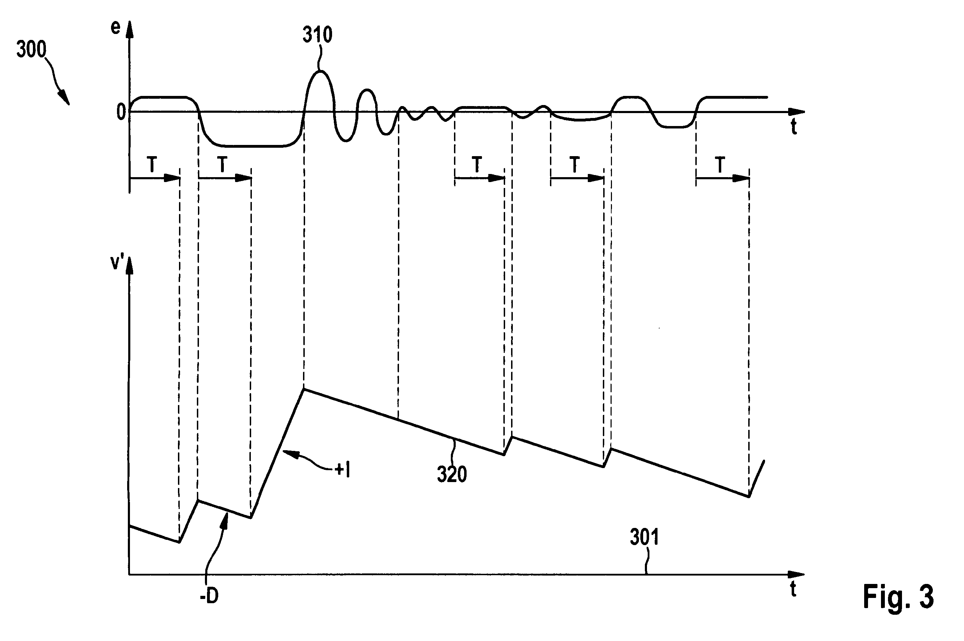

In Figur 3 sind in einem Diagramm 300 ein Verlauf 310 einer Regelabweichung e sowie der sich daraus ergebende Verlauf 320 des Lernwerts v' jeweils gegen die Zeit t auf einer Abszisse 301 aufgetragen. Es ist erkennbar, dass der Lernwert v' nach jedem Vorzeichenwechsel kontinuierlich verringert wird. Die Steigung in diesen Bereichen entspricht der negativen Integrationskonstanten -D. Tritt nach einem Vorzeichenwechsel innerhalb des vorgegebenen Zeitraums T kein erneuter Vorzeichenwechsel auf, steigt der Lernwert v' an. Die Steigung in diesen Bereichen entspricht der positiven Integrationskonstante +I.

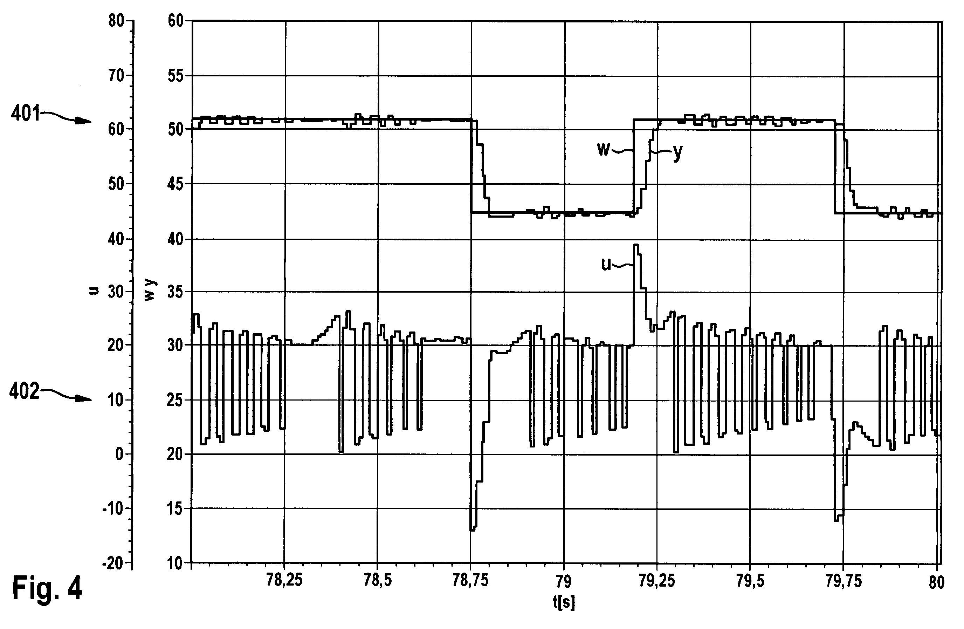

In Figur 4 sind in einem ersten Diagramm 401 Verläufe des Sollwerts w sowie des Istwerts y in Prozent gegen die Zeit t in Sekunden aufgetragen. Man erkennt, dass aufgrund der erfindungsgemäßen Regelung eine gute Übereinstimmung zwischen Soll- und Istwert erzielbar ist. In einem Diagramm 402 ist der zugehörige Verlauf der Stellgröße u in Prozent ebenfalls gegen die Zeit t in Sekunden aufgetragen. Die Stellgröße u berechnet sich, wie erläutert, auf Grundlage der Reglerausgangsgröße r sowie des Vorsteuerwerts v.

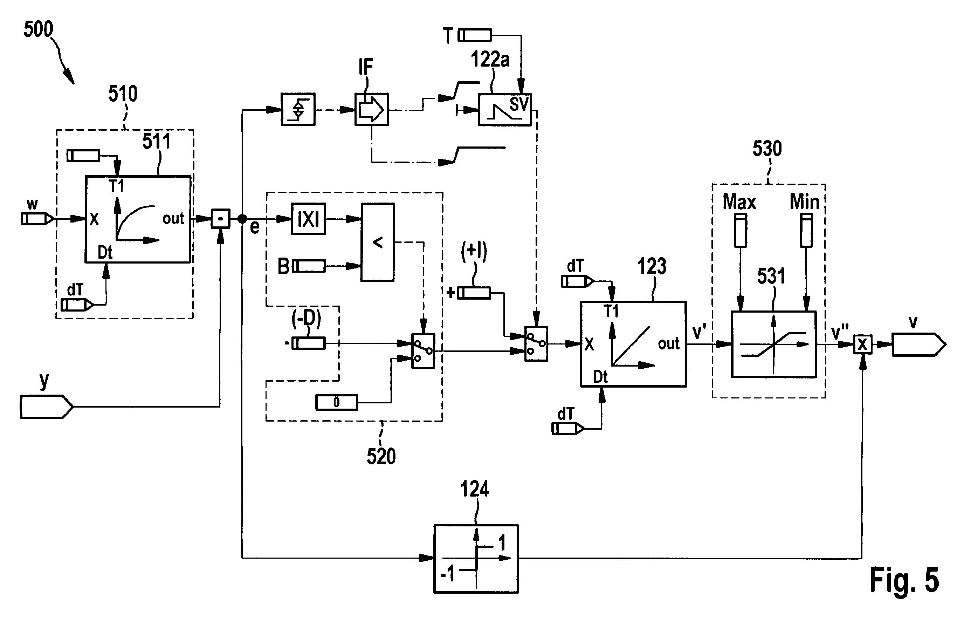

In Figur 5 ist eine weitere bevorzugte Ausführungsform eines Regelkreises 500 dargestellt. Der Regelkreis 500 basiert auf dem Regelkreis 100 gemäß Figur 1, wobei optionale Erweiterungen vorgesehen sind. Es sei zunächst darauf hingewiesen, dass die Erweiterungen unabhängig voneinander sind und somit auch unabhängig voneinander in einem Regelkreis vorgesehen sein können. Die in den Figuren 1, 2 und 5 gleichen Elemente sind mit gleichen Bezugszeichen versehen.

Eine erste bevorzugte Erweiterung innerhalb des Regelkreises 500 betrifft eine Filterung des Sollwerts w und ist mit 510 bezeichnet. Die Filterung wird vorliegend durch ein PT1-Glied 511 durchgeführt, um ein Rauschen des Sollwerts w ausfiltern, welches entsteht, weil der Sollwert w auf Grundlage von Messwerten berechnet wird.

Die zweite optionale Erweiterung ist mit 520 bezeichnet und dient zur Verminderung von Rauschen am Istwert. Rauschen am Istwert würde zu zusätzlichen Vorzeichenwechseln der Regelabweichung e führen, was wiederum zu einem zu kleinen Lernwert v' führen würde. Zur Lösung dieses Problems wird in der dargestellten bevorzugten Ausführungsform der Betrag der Regelabweichung e mit einem Band-Schwellwert B verglichen. Ist der Betrag der Regelabweichung e größer als der Band-Schwellwert B, wird die bereits erläuterte Integrationskonstante -D angelegt. Ist jedoch die Regelabweichung e kleiner als der Bandschwellwert B, wird Null angelegt.

Eine dritte optionale Erweiterung ist mit 530 gekennzeichnet und betrifft eine Beschränkung des Lernwerts v'. Dazu wird der Lernwert v' an ein Begrenzungsglied 531 geführt, das den Lernwert v' zwischen den Grenzen MIN und MAX hält und einen - ggf. begrenzten - Lernwert v" ausgibt. Wenn der Lernwert v' eine der beiden Grenzen verlässt, so wirkt ein sog. "Anti-Reset-Windup", der ein Aufziehen des Integrators verhindert. Wenn die MAX-Grenze überschritten ist, wird verhindert, dass der Lernwert v' weiter steigt, hingegen bleibt ein Verringern des Lernwerts v' möglich. Wenn die MIN-Grenze unterschritten ist, wird verhindert, dass der Lernwert v' weiter fällt, hingegen bleibt ein Erhöhen des Lernwerts v' möglich.

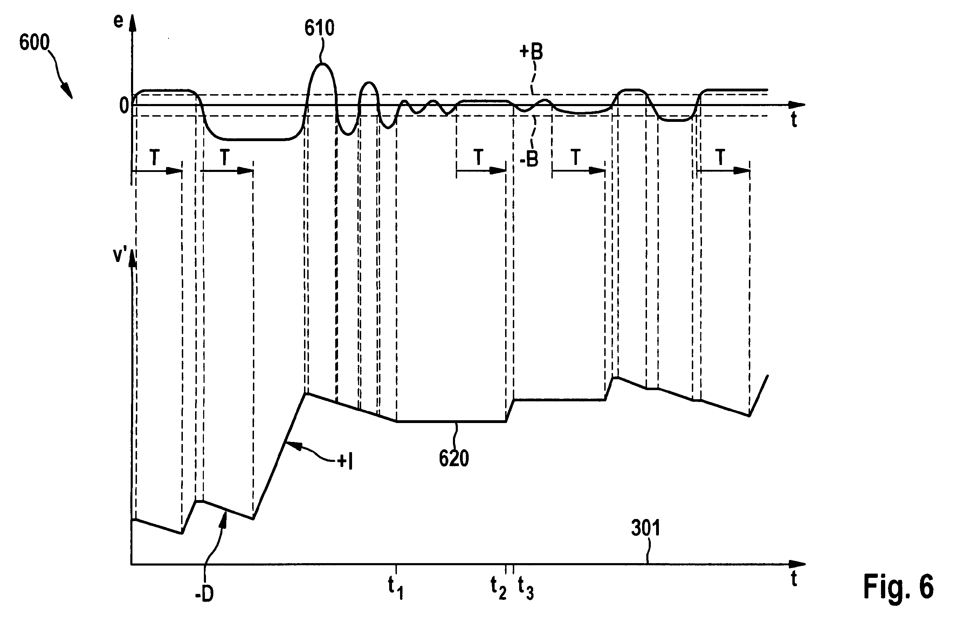

In Figur 6 ist ein dem Diagramm 300 gemäß Figur 3 entsprechendes Diagramm 600 dargestellt, dass den zeitlichen Verlauf 610 einer Regelabweichung e und den sich daraus ergebenden Verlauf 620 des Lernwerts v' unter Anwendung eines Regelkreises 500 gemäß Figur 5 zeigt. Die Elemente in Figur 6, die den Elementen in Figur 3 entsprechen, sind mit denselben Bezugszeichen bezeichnet und werden an dieser Stelle nicht erneut beschrieben.

Durch Anwendung der Filterung 520 kommt es nach jedem Vorzeichenwechsel der Regelabweichung e zunächst zu einem horizontalen Verlauf des Lernwerts v', bis die Regelabweichung e den durch den Band-Schwellwert B definierten Bereich verlässt. Es ist erkennbar, dass dies nach einem Zeitpunkt t₁ für längere Zeit nicht geschieht, so dass sich der Lernwert v' nach dem Zeitpunkt t₁ zunächst nicht mehr verändert. Während der gesamten Zeit wird jedoch weiterhin der Ablauf des Zeitintervalls T überwacht, sodass zu einem Zeitpunkt t₂ eine Erhöhung des Lernwerts v' durchgeführt wird. Die Erhöhung wird bis zum nächsten Vorzeichenwechsel zum Zeitpunkt t₃ durchgeführt, wobei anschließend erneut keine Verringerung des Lernwerts v' durchgeführt wird, da die Regelabweichung den durch den Band-Schwellwert B definierten Bereich um den Vorgabewert, hier Null, nicht verlässt.

## Patentansprüche

1. Verfahren zum Regeln der durch eine Reibung gehemmten Bewegung eines Bauteils oder Maschinenelements, wobei eine adaptive Vorsteuerung durchgeführt wird, bei der die Stellgröße (u) zur Kompensation eines Reibungseinflusses mit einem veränderlichen Vorsteuerwert (v) beaufschlagt wird, wobei die Veränderung des Vorsteuerwerts (v) in Abhängigkeit von einer Regelabweichung (e) als Differenz zwischen einem Sollwert (w) und einem Istwert (y) bestimmt wird, wobei die Veränderung des Vorsteuerwerts (v) auf Grundlage der Betrachtung des zeitlichen Verlaufs (310, 610) der Differenz zwischen der Regelabweichung (e) und einem Vorgabewert im Hinblick auf Vorzeichenwechsel bestimmt wird, **dadurch gekennzeichnet, dass** bei einem Vorzeichenwechselder Betrag des Vorsteuerwerts (v) verringert wird.

2. Verfahren nach Anspruch 1, wobei der Betrag des Vorsteuerwerts (v) erhöht wird, wenn innerhalb eines vorgegebenen Zeitraums (T) kein Vorzeichenwechsel auftritt.

3. Verfahren nach einem der vorstehenden Ansprüche, wobei die Veränderung des Vorsteuerwerts (v) schrittweise oder kontinuierlich, insbesondere unter Verwendung eines Integrierglieds (123), erfolgt.

4. Verfahren nach einem der vorstehenden Ansprüche, wobei ein Vorzeichenwechsel nur berücksichtigt wird, wenn der Betrag der Differenz zwischen der Regelabweichung (e) und dem Vorgabewert nach dem Vorzeichenwechsel einen vorgebbaren Band-Schwellwert (B) überschreitet.

5. Verfahren nach einem der vorstehenden Ansprüche, wobei der Betrag des Vorsteuerwerts (v) begrenzt wird.

6. Verfahren nach einem der vorstehenden Ansprüche, wobei der in die Regelabweichung (e) eingehende Sollwert (w) rauschgefiltert wird.

7. Verfahren nach einem der vorstehenden Ansprüche, wobei der Betrag des Vorsteuerwerts (v) nicht verändert wird, wenn sich das Bauteil oder Maschinenelement an einem Anschlag befindet.

8. Verfahren nach einem der vorstehenden Ansprüche, wobei der Betrag des Vorsteuerwerts (v) verringert wird, wenn eine Schwingung der Bewegung des Bauteils oder Maschinenelements erkannt wird.

9. Verfahren nach einem der vorstehenden Ansprüche, wobei die Art der Bestimmung des Vorsteuerwerts (v) in Abhängigkeit von der Geschwindigkeit der Bewegung des Bauteils oder Maschinenelements verändert wird

10. Verfahren nach einem der vorstehenden Ansprüche, wobei der Vorsteuerwert (v) in Abhängigkeit von der Geschwindigkeit der Bewegung des Bauteils oder Maschinenelements korrigiert wird.

11. Verfahren nach einem der vorstehenden Ansprüche, wobei die Bewegung einer Klappe eines Abgasrückführventils geregelt wird, wobei insbesondere in Abhängigkeit von der Istposition der Klappe und einem Abgasgegendruck der Vorsteuerwert verändert wird..

12. Recheneinheit, die dazu eingerichtet ist, ein Verfahren nach einem der vorstehenden Ansprüche durchzuführen.

## Claims

1. Method for controlling the movement of a component or machine element inhibited by friction, there being carried out an adaptive precontrol in the case of which a variable precontrol value (v) is applied to the manipulated variable (u) in order to compensate a frictional influence, the variation in the precontrol value (v) being determined, as a function of a system deviation (e), as the difference between a desired value (w) and an actual value (y), the variation in the precontrol value (v) being determined on the basis of observing the time profile (310, 610) of the difference between the system deviation (e) and a default value with regard to changes in sign, **characterized in that** the absolute value of the precontrol value (v) is reduced upon a change in sign.

2. Method according to Claim 1, in which the absolute value of the precontrol value (v) is raised when no change in sign occurs within a prescribed period (T).

3. Method according to one of the preceding claims, in which the variation in the precontrol value (v) occurs in stepwise or continuous fashion, in particular with the use of an integrating element (123).

4. Method according to one of the preceding claims, in which a change in sign is considered only when the absolute value of the difference between the system deviation (e) and the default value exceeds a prescribable band threshold (B) after the change in sign.

5. Method according to one of the preceding claims, in which the absolute value of the precontrol value (v) is limited.

6. Method according to one of the preceding claims, in which the desired value (w) present in the system deviation (e) is noise filtered.

7. Method according to one of the preceding claims, in which the absolute value of the precontrol value (v) is not changed when the component or machine element is located at a stop.

8. Method according to one of the preceding claims, in which the absolute value of the precontrol value (v) is reduced when a fluctuation of the movement of the component or machine element is detected.

9. Method according to one of the preceding claims, in which the type of determination of the precontrol value (v) is varied as a function of the speed of the movement of the component or machine element.

10. Method according to one of the preceding claims, in which the precontrol value (v) is corrected as a function of the speed of the movement of the component or machine element.

11. Method according to one of the preceding claims, in which the movement of a flap of an exhaust gas recirculation valve is controlled, in particular the precontrol value being varied as a function of the actual position of the flap and an exhaust gas back pressure.

12. Arithmetic logic unit which is set up to carry out a method according to one of the preceding claims.

## Revendications

1. Procédé de régulation du mouvement d'un composant ou d'un élément de machine gêné par un frottement, une commande pilote adaptative étant effectuée, lors de laquelle le grandeur de commande (u) est chargée avec une valeur pilote (v) variable en vue de compenser l'influence d'un frottement, la modification de la valeur pilote (v) étant déterminée en fonction d'un écart de régulation (e) sous la forme de la différence entre une valeur de consigne (w) et une valeur réelle (y), la modification de la valeur pilote (v) étant déterminée sur la base de l'observation du tracé dans le temps (310, 610) de la différence entre l'écart de régulation (e) et une valeur prédéfinie en vue d'un changement de signe, **caractérisé en ce qu'**en présence d'un changement de signe, la valeur absolue de la valeur pilote (v) est réduite.

2. Procédé selon la revendication 1, selon lequel la valeur absolue de la valeur pilote (v) est augmentée si aucun changement de signe ne se produit pendant une période (T) prédéfinie.

3. Procédé selon l'une des revendications précédentes, selon lequel la modification de la valeur pilote (v) s'effectue par paliers ou en continu, notamment en utilisant un composant intégrateur (123).

4. Procédé selon l'une des revendications précédentes, selon lequel un changement de signe n'est pris en compte que si la valeur absolue de la différence entre l'écart de régulation (e) et la valeur prédéfinie après le changement de signe dépasse une valeur de seuil de bande (B) pouvant être prédéfinie.

5. Procédé selon l'une des revendications précédentes, selon lequel la valeur absolue de la valeur pilote (v) est limitée.

6. Procédé selon l'une des revendications précédentes, selon lequel la valeur de consigne (w) qui intervient dans l'écart de régulation (e) est soumise à un filtrage du bruit.

7. Procédé selon l'une des revendications précédentes, selon lequel la valeur absolue de la valeur pilote (v) n'est pas modifiée lorsque le composant ou l'élément de machine se trouve contre une butée.

8. Procédé selon l'une des revendications précédentes, selon lequel la valeur absolue de la valeur pilote (v) est réduite lorsqu'une oscillation du mouvement du composant ou de l'élément de machine est détectée.

9. Procédé selon l'une des revendications précédentes, selon lequel le mode de détermination de la valeur pilote (v) est modifié en fonction de la vitesse du mouvement du composant ou de l'élément de machine.

10. Procédé selon l'une des revendications précédentes, selon lequel la valeur pilote (v) est corrigée en fonction de la vitesse du mouvement du composant ou de l'élément de machine.

11. Procédé selon l'une des revendications précédentes, selon lequel le mouvement d'un clapet d'une soupape de recyclage des gaz d'échappement est régulé, la valeur pilote étant notamment modifiée en fonction de la position réelle du clapet et d'une contre-pression des gaz d'échappement de la valeur pilote.

12. Unité de calcul qui est conçue pour mettre en oeuvre un procédé selon l'une des revendications précédentes.
